(19) Europäisches Patentamt / European Patent Office / Office européen des brevets

(11) **EP 2 736 156 B1**

## (12) EUROPEAN PATENT SPECIFICATION

(45) Date of publication and mention
of the grant of the patent:
**08.01.2020 Bulletin 2020/02**

(51) Int Cl.:
**H02M 3/158** (2006.01)

(21) Application number: **12306464.4**

(22) Date of filing: **27.11.2012**

(54) **Voltage polarity detection for DCM/CCM boundary detection in DC/DC converters**

Spannungspolaritätserkennung für DCM-/CCM-Grenzerkennung in Gleichspannungswandlern

Détection de polarité de tension pour la détection de limite en DCM/CCM dans des convertisseurs CC/CC

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.05.2014 Bulletin 2014/22**

(73) Proprietor: **Telefonaktiebolaget LM Ericsson (publ)**
**164 83 Stockholm (SE)**

(72) Inventor: **Michal, Vratislav**
**38100 Grenoble (FR)**

(74) Representative: **Ericsson
Patent Development
Torshamnsgatan 21-23
164 80 Stockholm (SE)**

(56) References cited:
**EP-A2- 0 049 024     GB-A- 2 472 111
US-A- 4 119 960**

• **DAUBERT S J ET AL: "OPERATION AND
ANALYSIS OF CURRENT COPIER CIRCUITS",
IEE PROCEEDINGS G. ELECTRONIC CIRCUITS
& SYSTEMS, INSTITUTION OF ELECTRICAL
ENGINEERS. STEVENAGE, GB, vol. 137, no. 2,
PART G, 2 April 1990 (1990-04-02), pages 109-115,
XP000102778, ISSN: 0622-0039**
• **Stephen Bryson: "Using auto-zero comparator
techniques to improve PWM performance (Part 1
of 2)", , 23 June 2008 (2008-06-23), pages 1-3,
XP055336556, EE times Retrieved from the
Internet:
URL:http://www.eetimes.com/document.asp?do
c_id=1272455 [retrieved on 2017-01-18]**

**Description**

**BACKGROUND**

**Technical Field**

The present disclosure generally relates to DC/DC convertors and methods for DC/DC conversion. More particularly, it concerns a voltage polarity detection circuit adapted for the detection of Continuous Conduction Mode (CCM) to Discontinuous Conduction Mode (DCM) boundary of a switched DC/DC converter.

It finds application, for instance, in power-management platforms for wireless devices such as mobile phones, smart phones, digital audio players, PDAs, e-books readers, or the like.

**Related Art**

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

A DC/DC converter is an electronic circuit which converts a source of direct current (DC) from one voltage level to another, higher or lower voltage level. Electronic Switched Mode Power Supply (SMPS) circuits convert one DC voltage level to another, by controlling a switch to store the input energy temporarily and then release that energy to the output at a different voltage. The storage may be in either magnetic field storage components (inductors, transformers) or electric field storage components (capacitors). In magnetic DC/DC converters, the energy is periodically stored into and released from a magnetic field in an inductor or a transformer, typically in the range from 300 kHz to 10 MHz. By adjusting the duty cycle of the switching, i.e., the ratio of ON/OFF time of the switch, the amount of energy transferred to the output can be controlled. Usually, this is applied to control the output voltage, and therefore a switch driving circuit is adapted to sense the output voltage and generate a control signal for driving the switch.

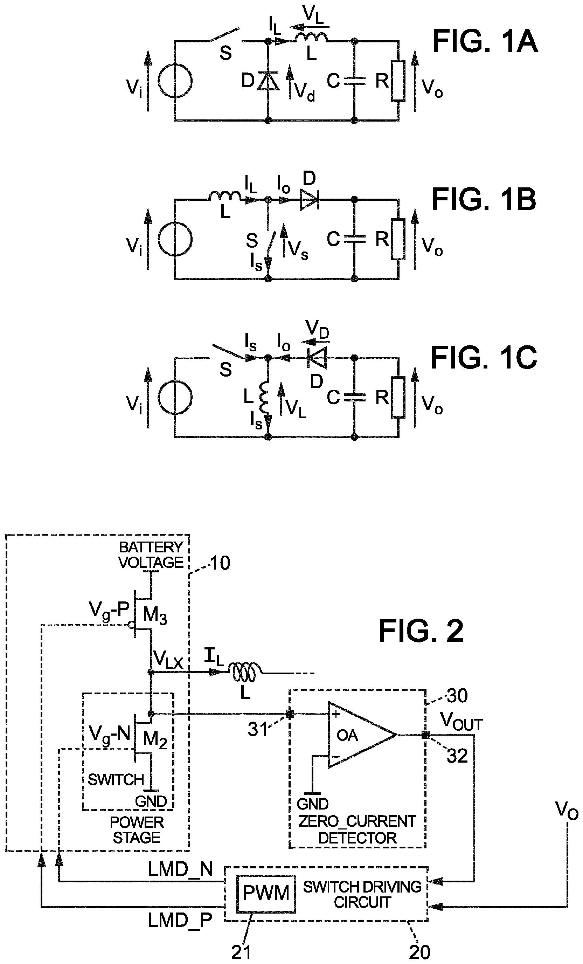

With reference to Figures 1A-1C, SMPS circuits achieve synchronous DC/DC conversion by means a converter comprising an inductance L switched by at least one power switch S controlled by a pulse-width modulated control signal, a capacitor C, a flywheel diode D acting as a rectifier, and a switch driving circuit (not shown) adapted to generate the control signal. The power switch S may be a power Metal Oxyde Semiconductor (power-MOS) transistor of the N-conduction type (commonly referred to as a NMOS) or of the P-conduction type (commonly referred to as a PMOS).

Depending on the arrangement of the inductor L, switch S, capacitor C and rectifying diode D, the DC/DC converter can be of the Buck, Boost or Buck-Boost type. A DC/DC converter of the Buck type (as shown in Figure 1A) allows reducing a DC input voltage $V_i$ or current to generate a lower DC output voltage or current. A DC/DC converter of the Boost type (as illustrated by Figure 1B) allows elevating a DC input voltage $V_i$ or current to generate a higher DC output voltage or current. A DC/DC converter of the Buck-Boost type (as illustrated by Figure 1C) is capable of performing both functions. In all types of DC/DC converters, the feedback circuit is adapted to generate the PWM control signal based on the DC output voltage $V_o$ (or current) across the load R, so as to regulate said DC output voltage (or current) to a desired value.

The efficiency of such DC/DC converters has increased thanks to the use of synchronous rectification, by replacing the flywheel diode with a power-MOS with lower ON-resistance, thereby reducing losses and allowing generation of supply voltages of lower value.

As shown in Figure 2, the switch S may be a PMOS power transistor $M_3$ arranged, in a power stage 10, in series with a NMOS power transistor $M_2$ acting as synchronous rectifier. Power transistors $M_2$ and $M_3$ are controlled by a driving signal CMD_N and a driving signal CMD_P, respectively. These signals may be generated by a Pulse-Width Modulation (PWM) unit 21 of the switch driving circuit 20, based on the output voltage $V_o$ of the converter (not shown in Figure 2 in which only the inductance L of the DC/DC converter is represented), that is to say the voltage across the load R as shown in Figures 1A-1C. In a Step-down (Buck) DC/DC converter, the output voltage is lower than the input voltage, and of the same polarity. In a Step-up (Boost) DC/DC converter, the output voltage $V_o$ is higher than the input voltage $V_i$. In a Single-Ended Primary-Inductor Converter (SEPIC) the output voltage $V_o$ can be lower or higher than the input voltage $V_i$ (Buck-Boost).

Discontinuous Conduction Mode (DCM) is a mode of operation of the DC/DC converter wherein in order to protect inductance current $I_L$ against polarity inversion during the conduction cycle of the power switch S, the power stage is disconnected (said power stage is in high impedance state). Likewise, Continuous conduction Mode (CCM) is a mode of the operation of DC/DC converter wherein the inductance current $I_L$ is not inverted during the conduction cycle. The converter operates in DCM when low current is drawn by the load R, and in CCM at higher load current levels. Indeed, when the amount of energy required by the load R is small enough to be transferred in a time lower than the switching period, the current through the inductor falls to zero during part of this period.

The DCM/CCM boundary detection is a fundamental functionality of each modern DC/DC convertor, enabling the convertor to be operated in various operating modes, for instance pure PWM mode or pulse-skipping mode. Pulse skipping mode is an operation mode which enables to decrease the power consumption of the DC/DC converter and thus to increase the battery-life of the mobile device, e.g, mobile phone. The accurate detection of the boundary between DCM and CCM is an important issue having a major role on the power efficiency and reliability of the DC/DC converter.

The boundary between the DCM and CCM is defined by the zero-valley inductor current, i.e. zero-current at the end of the NMOS conduction cycle. If this zero-current is not properly detected, the conduction on the PMOS transistor body-diode occurs, which considerably increases the power losses of the converter. In fact, when inductor current is inverted, the output capacitor is discharged by the power stage. This is opposite compared to the required features of the power stage, which is supposed to drive the power into the output capacitor during the whole PWM conduction cycle.

Therefore, and as shown further in Figure 2, the switch driving circuit 20 cooperates with a zero-current detection circuit 30, adapted to detect whether the inductor current $I_L$ changes polarity during or at the end of the conduction period of the power switch, namely of the NMOS in the shown example. Said zero-current detection circuit 30 has an input 31 connected to the output of the power switch, i.e., the drain of the NMOS power transistor $M_2$ in the shown example, for receiving its $V_{DS}$ voltage. Further, it has an output 32, whose output voltage $V_{OUT}$ in indicative of the polarity of the $V_{DS}$ voltage of the NMOS power transistor $M_2$, and is fed back to the switch driving circuit 20 along with the output voltage $V_o$ of the DC/DC converter.

There are two methods which may be used in practice to detect the current polarity of the inductor current $I_L$ at the end of NMOS conduction period. In a first method used in DC/DC convertors with low operating frequencies, the conduction on the body-diodes of the power-MOS is observed. In a second method suitable for DC/DC converters with higher switching frequency (when the non-overlapping time is not properly defined), the voltage $V_{DS}$ on the power-MOS drain is observed.

The present disclosure addresses DC/DC converters relying on this second polarity detection method.

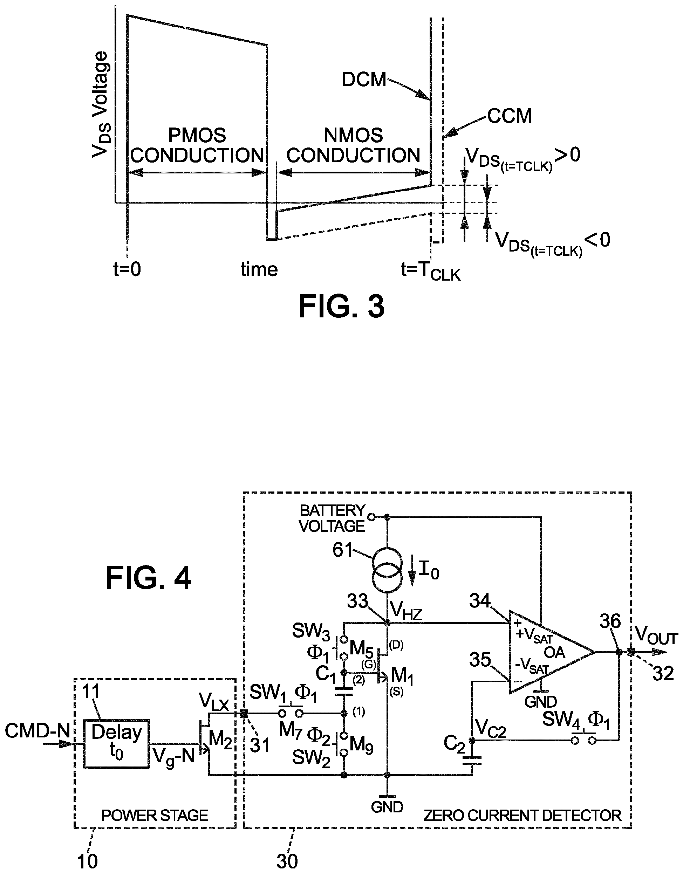

With reference to Figure 3, there is observed the polarity of the $V_{DS}$ voltage at the end of the conduction of the switch S, i.e., at time $t = T_{CLK}$, where $V_{DS}$ voltage refers to the drain-source voltage of the output NMOS power transistor. In the case of a negative voltage as shown by the curve in dotted line, no inversion occurs during the conduction period of the NMOS, which means that the converter operates in the CCM mode of operation. In contrast, when the voltage $V_{DS}$ at the end of the NMOS conduction period is positive as shown by the curve in continuous line, inversion occurs, and the pulse skipping mode is preferred in order to increase the power efficiency of the converter.

The voltage $V_{Ds(t=TCLK)}$ at the end of NMOS conduction period is equal to:

$$V_{DS_{(t=TCKLK)}} = I_{L_{(t=TCLK)}} \cdot R_{DS\_N} \tag{1}$$

where $R_{DS\_N}$ is the ON-resistance of the power NMOS and is in order of 100 mΩ. It follows that polarity detection circuit must handle with very low voltage levels, with accuracy below 1 mV, and must therefore be extremely accurate.

Zero-current detection solutions known in the art are based on a comparator having a differential input pair. In order to ensure the required accuracy, this comparator must either be trimmed after fabrication (which is expensive) or must use a special design technique, leading to important silicon surface and current consumption. When the comparator is not trimmed, the system must exhibit a high robustness due to increased dispersion, which considerably lowers the power efficiency of the convertor. Sometimes, an additional sensing resistance is inserted to increase the $V_{DS}$ voltage, which leads to additional power losses.

Other existing solutions also use sampling of the $V_{DS}$ voltage at the end of NMOS conduction period, which is subsequently evaluated with a slower, but more accuracy, differential pair based comparator.

Reference US 2011/291632 discloses a power converter which includes a power converting unit and a switch driving circuit. A zero-current detector is configured to adjust the offset voltage based on a first detection voltage signal generated by a switch driving circuit and to generate a zero-current detecting signal based on the offset voltage. The offset voltage and the zero-current detecting signal are associated with a current in the power converting unit.

Stephen Bryson: "Using auto-zero comparator techniques to improve PWM performance (Part 1 of 2)" discloses using auto-zero comparator techniques to improve PWM control used in power management. To eliminate offset variation inherent in conventional CMOS comparator circuits, an auto-zeroing comparator is provided where a DRIVE signal is used in combination with a capacitor C1 for changing the status of an output comparison signal.

EP 0 049 024 A2 discloses an operational amplifier designed to eliminate the effects of voltage offsets, wherein a switched capacitor is provided in a feedback loop of the operational amplifier.

This solution requires a high performance, i.e., high speed and high accuracy comparator, however leading to high power consumption, or requires post-fabrication trimming of the comparator to enhance its quality. Obtaining such high quality comparator contributes to an important part of the DC-DC convertor design, and it costs lots of resources.

An accurate CCM to DCM boundary detection would allow to improve the converter device features such as efficiency, and reliability of the control. This is a challenging improvement in particular for the devices having very low resistance of power switches. The design of a new offset-free polarity detection circuit can allow further improvement of the DC-DC convertors efficiency, mainly for higher switching frequencies, as required by the new power-management platforms for e.g. wireless devices.

## SUMMARY

These deficiencies are overcome, at least in part, by the invention defined in the subject matter of the independent claims. Advantageous embodiments are covered by the dependent claims.

To address these needs, embodiments of the proposed solution rely on detecting the inversion of the coil current at the end of the NMOS conduction cycle, defining the crossing of the DCM/CCM boundary, by using a design based on dynamic current mirror and auto-zero comparator providing an offset-free and very fast polarity detection.

More particularly, a first aspect relates to a voltage polarity detection circuit adapted for the detection of a Continuous Conduction Mode to Discontinuous Conduction Mode boundary of a power switch in a switched DC/DC converter, said circuit comprising:

- an input for receiving an input voltage representative of the conduction voltage of the power switch;

- an output for outputting a voltage polarity detection signal;

- a dynamic current mirror having an input connected to the input of the circuit through a first capacitor, and an output, said dynamic current mirror being controlled to store a voltage representative of the input voltage in the first capacitor at the end of a conduction cycle of the power switch; and,

- an auto-zero comparator having a first input connected to the output of the dynamic current mirror, a second input connected to a second capacitor, and an output connected to the output of the circuit, said auto-zero comparator being controlled to:

  - charge the output voltage of the dynamic current mirror into the second capacitor, during a first phase of operation corresponding to the conduction cycle of the NMOS power switch; and,

  - detect the polarity of the input voltage at the end of the first phase of operation, by comparing the voltage stored in the second capacitor with the output voltage of the dynamic current mirror in a second phase of operation corresponding to a non-conduction cycle of the power NMOS switch.

The dynamic current mirror acts as an input memory element and a first comparator stage, whereas the auto-zero comparator acts as a fast output stage providing additional voltage gain of the voltage polarity detection circuit. As it will become apparent from reading the following description of embodiments, the proposed circuit has the further advantages of having no inherent comparison offset and of having a very high detection speed (in the order of a few nanoseconds), along with very low power consumption.

A second aspect relates to a method of detecting a voltage polarity for the detection of a Continuous Conduction Mode to Discontinuous Conduction Mode boundary of a power switch used in a switched DC-DC converter, comprising:

- using a dynamic current mirror to store in a first capacitor a voltage representative of the conduction voltage of the power switch, at the end of a conduction cycle of the power switch; and,

- using an auto-zero comparator to:

  - charge the output voltage of the dynamic current mirror, into a second capacitor during a first phase of operation corresponding to the conduction cycle of the power switch; and,

  - detect, , the polarity of the conduction voltage of the power switch at the end of the first phase of operation, by comparing the voltage stored in the second capacitor during the first phase of operation with the output voltage of the dynamic current mirror in a second phase of operation corresponding to a non-conduction cycle of the power switch.

A third aspect relates to a DC-DC converter comprising a voltage polarity detection circuit according to the first aspect.

A fourth aspect relates to a wireless device comprising a Power Management Unit (PMU) having a DC-DC converter circuit according to the third aspect.

**BRIEF DESCRIPTION OF THE DRAWINGS**

Embodiments of the present invention are illustrated by way of example, and not by way of limitation, in the figures of the accompanying drawings, in which like reference numerals refer to similar elements and in which:

- Figures 1A, 1B and 1C are schematic views of a buck DC-DC converter, a boost DC-DC converter, and a buck-boost DC-DC converter, respectively.

- Figure 2 is a schematic view of a synchronous rectification DC-DC converter having a pull-up PMOS transistor and a pull-down NMOS transistor.

- Figure 3 is a graph of the drain voltage of the NMOS transistor as a function of time over the switching cycle of the DC-DC converter of Figure 2.

- Figure 4 is a schematic block diagram of a voltage polarity detection circuit used for the DCM/CCM boundary detection according to embodiments.

- Figure 5 are chronograms showing the waveform of the simplified schematic diagram from Figure 4.

- Figure 6 is a detailed schematic block diagram of a voltage polarity detection circuit used for the DCM/CCM boundary detection according to other embodiments.

- Figure 7 is a schematic block diagram of a wireless device incorporating a DC/DC converter as shown in Figure 4 or 6.

**DESCRIPTION OF PREFERRED EMBODIMENTS**

Various example embodiments will now be described more fully with reference to the accompanying drawings in which some embodiments are shown. The proposed inventive concepts may, however, be embodied in different forms and should not be construed as limited to the embodiments set forth herein. Rather, example embodiments are provided so that this disclosure is thorough and complete and fully conveys these inventive concepts to those skilled in the art.

Referring to Figure 4, there is shown therein a schematic block diagram of a voltage polarity detection circuit suitable for the DCM/CCM boundary detection according to embodiments of the proposed solution.

Embodiments rely on the association of a dynamic current mirror (also known as "current copier") together with a simple, i.e., low performance and low cost auto-zero comparator. In a dynamic current mirror, one and the same transistor is sequentially used at the input and the output of the mirror. Such current mirror is independent of the intrinsic and unavoidable mismatch between the at least two transistors of standard current mirrors or differential input pair, and thus has a very high accuracy. More details about dynamic current mirrors can be consulted in the book "Analogue IC Design: The Current-Mode Approach" - Chris Toumazou, F. J. Lidgey, David Haigh - 1993 - pp 302-303, Chapter 7.4 entitled "Principle of dynamic current mirrors".

In the contemplated implementation, the dynamic current mirror acts as the input memory element and a first comparator stage, whereas the auto-zero comparator acts as a fast output stage providing additional voltage gain of the voltage polarity detection circuit. As it will become apparent from reading the following description of embodiments, the proposed circuit has the further advantages of having no inherent comparison offset and of having a very high detection speed (in the order of a few nanoseconds), along with very low power consumption.

As shown in Figure 4, the voltage polarity detection circuit 10, also referred to as a zero-current detector in the present description, has an input 31 and an output 32. Only the NMOS power transistor $M_2$ of the power stage 10 is represented in Figure 4. Also, the switch driving circuit 20 as shown in Figure 2 is not represented in Figure 4, in order to keep the latter as simple and readable as possible. However, the one with ordinary skills in the art will understand that the proposed zero-current detector of Figure 4 is adapted to be substituted to the zero-current detector of Figure 2, namely may have its input 31 terminal and output terminal 32 connected to the same elements of the power stage 10 and the switch driving circuit 20 as described above with reference to Figure 2. More precisely, the input terminal 31 is connected to the output, i.e., the drain of the NMOS transistor $M_2$ of the power stage 10, and the output terminal 32 is connected to an input of the switch driving circuit 20 to feed-back the zero-current detection signal $V_{OUT}$.

In the embodiment shown if Figure 4, the power stage 30 further comprises a delay unit 11, which is adapted to delay the control signal CMD_N by a given time $t_0$. This ensures the absence of overlapping between the conduction periods of the power switch $M_2$ controlled by signal CMD_N on one hand, and power transistor $M_3$ controlled by the control signal CMD_P on the other hand.

Embodiments of the proposed polarity detection circuit 30 used for the detection of the Direct Current Mode (DCM) of the power switch $M_2$ comprise a dynamic current mirror and an auto-zero comparator, the combination of which provides a fast, accurate and offset-free polarity detection.

As shown in Figure 4, the dynamic current mirror may comprise a single NMOS transistor $M_1$, whose drain is connected to a current source 61 for receiving a constant current $I_0$ output from said current source. The source of $M_1$ is connected to the ground GND. The control gate of $M_1$ is connected to the input 31 of the circuit through a capacitor $C_1$ and a first switch $SW_1$. It is further connected to the ground GND through capacitor $C_1$ and a second switch $SW_2$. The control gate of $M_1$ is finally connected to its drain through a third switch $SW_3$. Let us call $V_{HZ}$ the voltage at the node corresponding to the drain of transistor M1, which thus also corresponds to the output voltage of the dynamic current mirror.

Further, the auto-zero comparator may comprise a standard two stage Operational Amplifier (OA) whose non inverting input "+" is connected to the drain of $M_1$, whose inverting input "-" is connected to the ground through a capacitor $C_2$, and whose output is connected to its inverting input "-" through a fourth switch $SW_4$. Let us call $V_{C2}$ the voltage across capacitor $C_2$, and $V_{OUT}$ the voltage at the output of the AO. Voltage $V_{OUT}$ is also the output voltage of the auto-zero comparator and, hence, the voltage at the output 32 of the polarity detection circuit 30.

In one example, switches $SW_1$, $SW_2$, $SW_3$ and $SW_4$ each comprise, for instance are implemented by, e.g., a NMOS transistor $M_7$, $M_9$, $M_5$ and $M_{12}$, respectively.

Switches $SW_1$, $SW_3$ and $SW_4$ on one hand, and switch $SW_2$, on the other hand, are driven by two complementary clock signals $\Phi_1$ and $\Phi_2$, respectively.

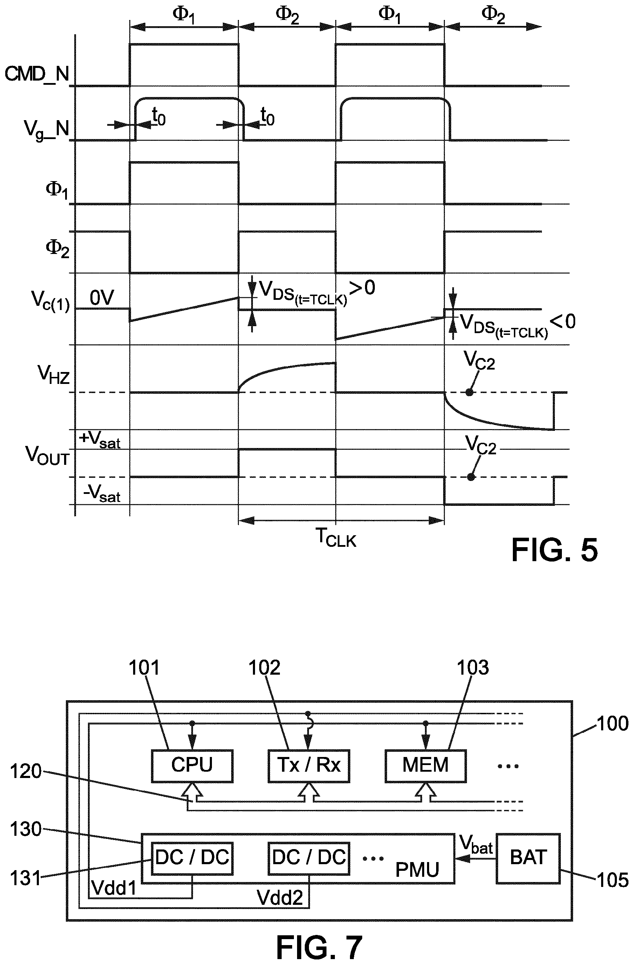

The operation of the circuit of Figure 4 will now be detailed with reference to the simplified chronograms of Figure 5.

The first chronogram at top of Figure 5 shows the pulse-width modulated control signal CMD_N generated by the switch driving circuit 20 for driving the power switch $M_2$. The second chronogram corresponds to the voltage $V_g\_N$ on the control gate of transistor $M_2$, showing in particular the delay $t_0$ introduced by the delay unit 11 of the power stage 10. The third and fourth chronograms show the complementary clock signals $\Phi_1$ and $\Phi_2$. These clock signals $\Phi_1$ and $\Phi_2$ may be generated by the switch driving circuit 20. They have the same period as the control signals CMD_N and CMD_P, which may correspond to the period $T_{CLK}$ of a master clock CLK of the power management unit which incorporates the DC-DC converter. Control signal CMD_N is in phase with clock signal $\Phi_1$, and control signal CMD_P is in phase with clock signal $\Phi_2$. Note, however, that a slight non-overlap of the $\Phi_1$ and $\Phi_2$ clock signals may be introduced.

The operation of the polarity detection circuit 30 is cyclic, one cycle corresponding to a period of the complementary clock signals $\Phi_1$ and $\Phi_2$. A cycle is divided in two phases of operation.

A first phase of operation is defined by the time when clock signal $\Phi_1$ is active, for example at the high logical state, and control signal $\Phi_2$ is inactive, at the low logical state in such example. Conversely, the second phase of operation is defined by the time when clock signal $\Phi_1$ is inactive and control signal $\Phi_2$ is active. In view of the above convention, the first phase of operation will sometimes be referred to as phase $\Phi_1$, and the second phase of operation will be referred to as phase $\Phi_2$, in what follows.

The NMOS transistor $M_2$ of the power stage is conductive during the first phase of operation (i.e., phase $\Phi_1$), and is blocked during the second phase of operation (i.e., phase $\Phi_2$). Stated otherwise, the first phase of operation of the polarity detection circuit corresponds to the conduction period of the power transistor $M_2$ of the DC-DC converter. Also, the switches $SW_1$, $SW_3$ and $SW_4$ are closed during the first phase of operation, and are open during the second phase of operation. Conversely, switch $SW_2$ is open during the first phase of operation, and is closed during the second phase of operation.

During phase $\Phi_1$, the drain-source voltage $V_{DS}$ of the power NMOS transistor $M_2$ is applied to the first terminal (1) of the memory capacitor $C_1$ through the closed switch $SW_1$. Switch $SW_3$, being closed, configures the transistor $M_1$ to be diode-connected. The terminal (2) of capacitor $C_1$ on the side of switch $SW_3$ is at the voltage gate-source voltage $V_{GS(M1)}$ of transistor $M_1$, which is therefore given by:

$$V_{GS(M1)} = \sqrt{\frac{2I_D}{\mu_0 C_{ox}} \frac{L}{W}} + V_{TH} \qquad (2)$$

where :

    $I_D$ is the drain current flowing through $M_1$;
    L and W designate the length and the width, respectively, of $M_1$; and,

$V_{TH}$ is the threshold voltage of $M_1$.

If follows that, during phase $\Phi_1$, the voltage $V_{C1}$ across the capacitor $C_1$ is given by:

$$V_{C1} = V_{GS(M1)} - V_{DS(M2)} \qquad\qquad (3)$$

where $V_{DS(M2)}$ is the drain-source voltage of the power transistor $M_2$.

It will be appreciated that voltage $V_{C1}$ is thus directly representative of voltage $V_{DS(M2)}(t)$, since the drain current $I_D$ is flowing through $M_1$ is equal to the constant current $I_0$ from current source 61 ($I_D = I_0$), so that voltage $V_{GS(M1)}$ is constant during phase $\Phi_1$. Voltage $V_{C1}$ across capacitor $C_1$ as a function of time is shown by the fifth chronogram from the top of Figure 5.

During this phase $\Phi_1$, the auto-zero comparator, namely the Operational Amplifier OA, is configured as a voltage follower (switch $SW_4$ being closed). Thus, the substantially constant voltage $V_{Hz}$ at the high-impedance node corresponding to the drain of transistor $M_1$, is recopied to the capacitor $C_2$ as voltage $V_{C2}$. Voltage $V_{HZ}$ as a function of time is shown in the sixth chronogram from the top of Figure 5. It may be noted, that an eventual offset of the comparator is added to the $V_{C2}$.

Let us now describe the configuration of the circuit in the second phase $\Phi_2$. In phase $\Phi_2$, terminal (1) of capacitor $C_1$ on the side of switch $SW_2$ is connected to the ground GND through closed switch $SW_2$, and switches $SW_1$, $SW_3$ and $SW_4$ are open. Whatever the polarity of the drain-source $V_{DS}$ of $M_1$ voltage at the end of first phase $\Phi_1$ (noted $V_{DS(t=TCLK)}$ in Figure 5), namely irrespective of whether voltage $V_{DS(M2)}$ is positive or negative at the end of the conduction period of the NMOS transistor $M_2$, a complementary, i.e. negative or positive excursion will immediately appear on the gate of transistor $M_1$. Indeed, the voltage across capacitor $C_1$ remains constant upon switching of transistor $M_2$ from the conduction state to the non-conduction state. Further, from the end of phase $\Phi_1$ and beginning of phase $\Phi_2$ we have the following relationship:

$$V_{C1} = V_{GS(M1)} \qquad\qquad (4)$$

Thus, comparing above relations (3) and relation (4) at $t=T_{CLK}$, gives the following changes in the gate-source voltage $V_{GS(M1)}$ of transistor $M_1$ :

- if the drain-source voltage $V_{DS(t=TCLK)}$ of transistor $M_2$ at the end of phase $\Phi_1$ is positive (as shown on the left part of the fifth chronogram from top of Figure 5 which corresponds to the case illustrated by the graph in continuous line of Figure 3), then the gate-source voltage $V_{GS}$ of transistor $M_1$ is shifted down by $V_{DS(t=TCLK)}$. It follows that voltage $V_{GS(M1)}$ of transistor $M_1$ at the beginning of phase $\Phi_2$ is lower than at the end of phase $\Phi_1$ (which may be expressed as $V_{GS(\Phi2)} < V_{GS(\Phi1)}$); and, conversely,

- if the drain-source voltage $V_{DS(t=TCLK)}$ of transistor $M_1$ at the end of phase $\Phi_1$ is negative (as shown on the right part of the fifth chronogram from top of Figure 5 which corresponds to the case illustrated by the graph in dotted line in Figure 3), then the gate-source voltage $V_{GS}$ of transistor $M_1$ is shifted up by the absolute value of $V_{DS(t=TCLK)}$. It follows that voltage $V_{GS(M1)}$ of transistor $M_1$ at the beginning of phase $\Phi_2$ is higher than at the end of phase $\Phi_1$ (which may be expressed as $V_{GS(\Phi2)} > V_{GS(\Phi1)}$)-

This implies the following changes in the drain-source voltage $V_{DS}$ of transistor $M_1$, as shown in the sixth chronogram from the top of Figure 5, on the left side, and on the right side, respectively, wherein the substantially constant value $V_{C2}$ stored in capacitor $C_2$ is represented by a horizontal dotted line:

- when $V_{GS(\Phi2)} < V_{GS(\Phi1)}$, then voltage $V_{DS}$ of $M_1$ increases from voltage value $V_{C2}$; and, conversely,

- in the opposite case when $V_{GS(\Phi2)} > V_{GS(\Phi1)}$, then the drain voltage $V_{DS}$ of $M_1$ decreases from the value $V_{C2}$ stored in capacitor $C_2$.

Let us now concentrate on the operation of the auto-zero comparator.

In phase $\Phi_1$, the switch $SW_4$ is closed thereby connecting the output voltage of the AO to its inverting, i.e., negative or "-" input. The AO is thus configured to operate as a voltage follower, as already stated above. Its output voltage, which thus corresponds to the $V_{HZ}$ voltage plus any offset value of the AO, is charged into capacitor $C_2$.

In phase $\Phi_2$, the switch $SW_4$ is open and the AO thus operates as a comparator, whereby its output voltage is at $+V_{sat}$ if $V_{HZ} > V_{C2}$, and at $-V_{sat}$ if $V_{HZ} < V_{C2}$, where $+V_{sat}$ and $-V_{sat}$ are the positive and negative saturation voltages, respectively, of the AO, which corresponds to its high supply voltage and its low supply voltage, respectively. In one example, the high supply voltage corresponds to the battery voltage $V_I$ of the device, and the low supply voltage corresponds to the potential of the ground GND, namely 0 Volt.

To summarize, and as is illustrated by the last chronogram at the bottom of Figure 5, the output voltage $V_{OUT}$ of the comparator is:

- at voltage $V_{C2}$ during phase $\Phi_1$, said voltage $V_{C2}$ being substantially constant and mainly defined by the current $I_0$ output by current source 61;
- at voltage $+V_{sat} = V_I$ (where $V_I$ is, e.g., the battery voltage) during phase $\Phi_2$ in the case where $V_{DS(t=TCLK)} > 0$, namely in the inverted coil current mode of operation of the DC/DC converter; and,
- at voltage $-V_{sat}$ (e.g 0 Volt) during phase $\Phi_2$ in the case where $V_{DS(t=TCLK)} < 0$, namely in the CCM mode of operation of the converter.

In other words, the output signal $V_{OUT}$ at the output of the zero-current detector 30 is indicative of the polarity of the drain-source voltage $V_{DS(t=TCLK)}$ of the power transistor $M_2$ at the end of its conduction phase $\Phi_1$. Yet in other words, this output signal $V_{OUT}$ is representative of the result of the CCM/DCM boundary detection. Signal $V_{OUT}$ is used by the switch driving circuit 20 as shown in Figure 20, for defining the best switch strategy depending on the particular requirements of the contemplated application.

As can be understood by the one with ordinary skills in the art, using an auto-zero comparator as described above allows removing the effect of any offset of the AO, thus achieving an offset-free comparison result.

Besides, as the input voltage variation in gate-source voltage $V_{GS}$ of transistor $M_1$ from phase $\Phi_1$ to phase $\Phi_2$ can be very low, the voltage excursion in the $V_{HZ}$ node during phase $\Phi_2$ can be very slow. Nevertheless, one further advantage of the association of the dynamic current mirror with an auto-zero comparator is that voltage $V_{HZ(\Phi2)}$ is compared with voltage $V_{HZ(\Phi1)}$ (stored in $C_2$) by the auto-zero comparator whose output response is very fast. Therefore, as illustrated by the fifth, sixth and seventh chronograms from the top of Figure 5 showing voltages $V_{C1}$, $V_{HZ}$, and $V_{OUT}$, respectively, even a slow voltage ramp can be detected substantially immediately after the end of phase $\Phi_1$ and beginning of phase $\Phi_2$. This is due to the fact, that the comparator is pre-biased, $i.e.$ the starting-point of its output voltage variation is from an intermediate voltage value $V_{C2}$. This effects allow obtaining the comparison result in a very short time compared to the standard solutions.

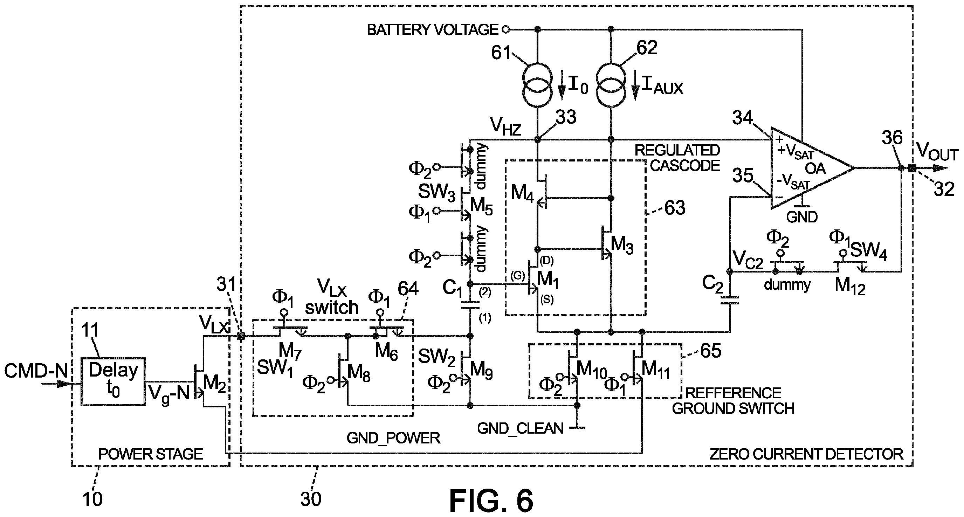

Further improvements of the proposed design will now be described with reference to the more elaborated schematic circuit diagram of Figure 6.

One key aspect of the accuracy of proposed solution as described above is to protect the capacitor voltage $V_{C1}$ during the switching from phase $\Phi_1$ to phase $\Phi_2$. This is because the capacitor $C_1$ stores the information about the compared voltage $V_{DS}$ of the power NMOS transistor $M_2$ of the DC-DC converter, and it is critical not to alter this information $V_{DS(=TCLK)}$ at the end of the conduction phase $\Phi_1$ of the power transistor $M_2$.

It will be noted that small amount of error current is passing through capacitor $C_1$. This is due to the constant voltage at the plate (2) given by Eq.(2), and a small variation of the $V_{DS(M2)}$ during the conduction of the NMOS transistor $M_2$. This variation is caused by the triangular shape of $I_L$ (see shape of $V_{C(1)}$ in the fifth graph from top of Figure 5). As a result, in order to bring this current to a few nanoampers, the value of capacitor $C_1$ should be very small, for instance 1 pF, or even less. This, however, makes the $V_{C1}$ voltage sensitive due to the possible charge injection caused by the switching. It will be appreciated that this is not valid for $C_2$ which can thus have a higher value.

Thus, some refinements of the basic design may be implemented, which will now be explained in more details. It will be appreciated, however, that these further embodiments may or not be implemented, either separately or in combination, in any manner suitable for the specific implementation. Stated otherwise, these further embodiments provide additional advantages but are not necessary for implementing the inventive principle of the proposed solution.

In one embodiment, for instance, provision can be made of a regulated cascode arrangement 63 for stabilising the $V_{DS}$ voltage of transistor $M_1$. This solution allows preventing eventual detection errors which may be caused by the charge injection through the drain-to-gate parasitic capacitance of transistor $M_1$.

This result may be achieved by the stabilisation of $V_{DS}$ voltage of $M_1$ with the help of at least one cascode stage in the dynamic current mirror, said cascode stage comprising two additional transistors $M_3$ and $M_4$. The source of $M_3$ is connected to the source of the main transistor $M_1$, its drain being connected to the battery voltage through an additional current source 62 delivering an additional constant current $I_{Aux}$, and it control gate being connected to the drain of the main transistor $M_1$. Transistor $M_4$ is cascaded with transistor $M_1$, i.e. arranged in series within the drain path of transistor $M_1$. More precisely, transistor $M_4$ is connected by its source to the drain of transistor $M_1$, and by its drain to the main current source 61 which delivers the main current $I_0$, having its control gate connected to the drain of transistor $M_3$ in the current path comprising the additional current source 62.

The stabilisation effect of this cascode arrangement is obtained at the cost of consumption of a small additional current $I_{AUX}$ of e.g. a few micro-amperes ($\mu$A).

In other embodiments, dummy switches may be used to prevent the "clock feed-through" effect from the clock signals. By "dummy switches", it must be understood dummy transistors, that is to say transistors of same technology as their associated main transistor, and having their current path short-circuited, namely their drain permanently connected to their source at silicon level. In the application considered here, the gate of any dummy transistor used as dummy switch receives a control clock signal which is complementary to the clock signal received by the gate of their associated main transistor.

For example, one or two such dummy switches may be associated to the third switch $SW_3$. For example, these dummy switches may be dummy transistors which have a size 0.5xW and 1xL, as compared with the size W and L of the main transistor $M_5$ of switch $SW_3$, respectively, and are provided in the current path of said main transistor $M_5$. In the shown example, one such dummy transistor is connected on each side of transistor $M_5$, namely on the drain side and the other on the source side of $M_5$. The former is adapted to prevent charge injection from transistor $M_5$ to the second capacitor $C_2$, and the latter is adapted to prevent charge injection from transistor $M_5$ to the first capacitor $C_1$. To that end, these dummy transistors are each controlled by the clock signal $\Phi_2$ which is complementary to the clock signal $\Phi_1$ controlling the transistor $M_5$ which implements the control switch $SW_3$.

It shall be appreciated that, other and possibly all control switches used in the zero-current may have one or two associated dummy switches. For instance, a dummy transistor may also be associated to the transistor $M_{12}$ of switch $SW_4$, as shown in Figure 6 as well. More precisely, a dummy transistor is provided in the current path of the transistor $M_{12}$ implementing the control switch $SW_4$, on the side of the second capacitor $C_2$, said dummy transistor being controlled by the clock signal $\Phi_2$ which is complementary to the clock signal $\Phi_1$ controlling said main transistor implementing the fourth control switch. Being so arranged, the dummy transistor associated with transistor $M_{12}$ of switch $SW_4$ is adapted to prevent charge injection from said transistor $M_{12}$ to the second capacitor $C_2$.

In still other embodiments, provision can be made of a serially connected series and shunt switching arrangement 64, avoiding leakage of the inductor voltage $V_{LX}$ at the drain of the power NMOS transistor $M_2$ when its body-diode is conducting.

In the shown example, such series and shunt switching arrangement is implemented at the first switch $SW_1$. Stated otherwise, the circuit comprises a series and shunt switching arrangement associated to the first switch $SW_1$. It may thus comprise, in addition to the serially connected transistor $M_7$ of switch $SW_1$ as described above, another serially connected transistor NMOS $M_6$ which is controlled by the same clock signal $\Phi_1$ as transistor $M_7$, and a parallel connected (i.e. shunt) NMOS transistor $M_8$ controlled by a clock signal which is complementary to $\Phi_1$, for instance by the clock signal $\Phi_2$.

In yet other embodiments, the clock signals $\Phi_1$ and $\Phi_2$ are generated by the switch driving circuit so as to be slightly non-overlapping, in order to avoid the cross-conduction current through the switches $SW_2$ and $SW_3$. By "non-overlapping" it must be understood that both signals are not active, i.e. for instance at the logical high state, at the same time. As shown by the three first chronograms from the top of Figure 5, clock signals $\Phi_1$ and $\Phi_2$ are driven by the NMOS control signal CMD_N instead of control voltage Vg_N. This allows sampling the drain-source voltage $V_{DS(t=TCLK)}$ of the NMOS transistor $M_1$ at the end of phase $\Phi_1$ slightly before the end of the transistor conduction, when the power stage 10 is still in steady-state.

In further embodiments the voltage polarity detection circuit may further comprise a reference ground switching arrangement 65. This allows that that the reference ground is the power ground GND_POWER of the power stage of the DC/DC converter during the first phase of operation $\Phi_1$, and is a "clean" ground GND_CLEAN, distinct from said power ground, during the second phase of operation $\Phi_2$. Indeed, it is better that the reference ground of the voltage polarity detection circuit be the power ground of the power stage of the DC/DC converter during the first phase of operation $\Phi_1$ because this provides a better accuracy of the copy of the drain-source voltage $V_{DS(M2)}$ of the power MOS transistor $M_2$ in the first transistor $C_1$. However, in the remaining of the time, that is to say during the second phase of operation $\Phi_2$, it is better that the reference ground the voltage polarity detection circuit be distinct from the power ground of the power stage of the DC/DC converter, because the latter may vary depending on the load current and may convey various kinds of interferences.

This result may be achieved, as shown in Figure 4, by providing in the reference ground switching arrangement 65, a first NMOS transistor $M_{10}$ in series between the source of the main transistor $M_1$ of the dynamic current source and the clean ground GND_CLEAN terminal, which is controlled by signal $\Phi_2$, and a second NMOS transistor $M_{11}$ in series between the source of transistor $M_1$ and the power ground GND_POWER terminal of the power stage 10, said transistor $M_{11}$ being controlled by signal $\Phi_1$.

Finally, some embodiments may implement a dynamic bias in order to provide very low current consumption. According to such embodiments, the circuit is powered during the first phase of operation $\Phi_1$ of the DC/DC converter, only until the voltage $V_{HZ}$ at the first input of the auto-zero comparator crosses the voltage $V_{C2}$ at the second input of said auto-zero comparator, and is then turned off to save current consumption until the beginning of the next conduction cycle of the power switch $M_2$ of the DC/DC converter, that is to say until the beginning of the next iteration of the first phase of operation $\Phi_1$ of the DC/DC converter. In other words, the circuit is switched off and is placed e.g. in a sleep mode, until the beginning of the next NMOS conduction cycle.

The design presented above has a major impact on the efficiency and reliability of the DC/DC converter for e.g. mobile-phone platforms. Using such architecture can bring a significant advancement compared to existing solutions and can also find usage in similar products, such as any type of wireless devices.

The block diagram in Figure 7 shows the elements of a wireless device 100 incorporating a DC/DC converter 110 as described above. Such a device 100 can be a mobile telephone, a smart phone, a digital audio player, a PDA, an e-book reader, or any other battery powered device.

The device 100 as shown comprises a control unit 101 such as a processor (CPU), and a number of functional units such as, for instance, a communication unit 102 for transmitting and receiving information to and from the outside, in particular by modulating a radio frequency carrier, a memory 103 which can store information in digital form, for example a piece of music, etc. The processor 101 communicates with the functional units like 102 and 103, via a communication bus 120. Each of the CPU and the functional units is powered from the battery voltage Vbat delivered by a battery 106, through a Power Management Unit (PMU) 130.

To generate supply voltages from the battery voltage Vbat, the PMU 130 comprises at least one voltage DC/DC converter 131 of the SMPS type, for which embodiments have been described above. More than one such DC/DC converter may be provided for generating a plurality of supply voltages Vdd1, Vdd2, ... of different values for e.g. supplying respective groups of functional units, and/or respective functional blocks thereof. The DC/DC converters may be of any one of the buck, boost or buck-boost type, as previously described with reference to Figures 1A-1C.

Unless otherwise defined, all terms (including technical and scientific terms) used herein have the same meaning as commonly understood by one of ordinary skill in the art to which inventive concepts belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of inventive concepts.

The terminology used herein is for the purpose of describing particular embodiments only and is not intended to be limiting of inventive concepts. As used herein, the singular forms "a," "an" and "the" are intended to include the plural aims as well, unless the context clearly indicates otherwise.

Also; expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

While there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above. Therefore, it is intended that the present invention not be limited to the particular embodiments disclosed, but that the invention include all embodiments falling within the scope of the appended claims.

The present invention can be implemented in hardware, software, or a combination of hardware and software. Any processor, controller, or other apparatus adapted for carrying out the functionality described herein is suitable. A typical combination of hardware and software could include a general purpose microprocessor (or controller) with a computer program that, when loaded and executed, carries out the functionality described herein.

The present invention can also be embedded in a computer program product, which comprises all the features enabling the implementation of the methods described herein, and which - when loaded in an information processing system - is able to carry out these methods. Computer program means or computer program in the present context mean any expression, in any language, code or notation, of a set of instructions intended to cause a system having an information processing capability to perform a particular function either directly or after either or both of the following a) conversion to another language. Such a computer program can be stored on a computer or machine readable medium allowing data, instructions, messages or message packets, and other machine readable information to be read from the medium. The computer or machine readable medium may include non-volatile memory, such as ROM, Flash memory, Disk drive memory, CD-ROM, and other permanent storage. Additionally, a computer or machine readable medium may include, for example, volatile storage such as RAM, buffers, cache memory, and network circuits. Furthermore, the computer or machine readable medium may comprise computer or machine readable information in a transitory state medium such as a network link and/or a network interface, including a wired network or a wireless network, that allow a device to read such computer or machine readable information.

A person skilled in the art will readily appreciate that various parameters disclosed in the description may be modified and that various embodiments disclosed and/or claimed may be combined without departing from the scope of the invention.

It is stipulated that the reference signs in the claims do not limit the scope of the claims, but are merely inserted to enhance the legibility of the claims.

**Claims**

1. A voltage polarity detection circuit (30) comprising:

   an input (31) configured to receive an input voltage (VLx) representative of the conduction voltage of a power switch FET;
   an output (32) configured to output a voltage polarity detection signal;
   a current source (61) adapted to output a constant current (10);
   a MOS transistor (M1) having:

   - a drain connected to the current source for receiving said constant current,
   - a gate connected to the input through a first capacitor (C1) and a first control switch (SW1), to its drain through a third control switch (SW3) and to a first power supply (GND) through the first capacitor (C1) and a second control switch (SW2); and
   - a source connected to the first power supply (GND);

   **characterized in that** the voltage polarity detection circuit (30) is further comprising:
   a comparator comprising an Operational Amplifier (OA) having:

   - a non-inverting input connected to the drain of the MOS transistor,
   - an inverting input connected to the first power supply (GND) through a second capacitor (C2), and
   - an output connected to the non-inverting input through a fourth control switch (SW4) and to the output (32); wherein the voltage polarity detection circuit (30) is configured so that:

      during a first phase of operation ($\varphi 1$) corresponding to a conduction cycle of the power is open, such that an output voltage ($V_Hz$) of the MOS transistor (M1) is charged into the second capacitor ($C_2$); and during a second phase of operation ($\Phi_2$) corresponding to a non-conduction cycle of the power switch FET; the first, second and fourth control switches are open and the third control switch is closed, and the polarity of the input voltage (VLx) at the end of the first phase of operation is detected by comparing the voltage stored in the second capacitor with the output voltage (VHz) of the MOS transistor; and wherein the first, second and fourth control switches are driven by a first clock signal and the third control switch is driven by a second clock signal complementary to the first clock signal.

2. The voltage polarity detection circuit of claim 1, further comprising a cascode stage having a first additional MOS transistor ($M_3$) whose source is connected to the source of the main MOS transistor ($M_1$), whose drain is connected to an additional current source (62) adapted to output an additional constant current ($I_{aux}$), and whose control gate is connected to the drain of said main transistor ($M_1$), as well as a second additional MOS transistor ($M_4$) whose source is connected to the drain of the main transistor ($M_1$), whose drain is connected to the main current source (61) for receiving the main constant current ($I_0$), and whose control gate is connected to the drain of the first additional transistor ($M_3$).

3. The voltage polarity detection circuit of claim 1 or 2, wherein the third control switch ($SW_3$) is implemented by a main transistor ($M_5$) the voltage polarity detection circuit further comprising a first and/or a second dummy transistor provided in the current path of said main transistor implementing the third control switch, on either side of said main transistor implementing the third control switch, respectively, namely on the drain side and on the source side of said main transistor, respectively, said first and/or second dummy transistors each being controlled by the first clock signal.

4. The voltage polarity detection circuit of claim 3, wherein the first and/or second dummy transistors have a size 0.5xW and 1xL, as compared with the size W and L of said main transistor, respectively.

5. The voltage polarity detection circuit of any one of claims 1 to 4, wherein the fourth control switch ($SW_4$) is implemented by a main transistor ($M_{12}$), the voltage polarity detection circuit further comprising a dummy transistor provided in the current path of said main transistor implementing the fourth control switch, on the side of the second capacitor ($C_2$) said dummy transistor being controlled by the second clock signal.

6. The voltage polarity detection circuit of any one of claims 1 to 5, wherein the first control switch ($SW_1$) is implemented by a main transistor ($M_7$), the voltage polarity detection circuit further comprising a series and shunt switching arrangement (64) associated to said main transistor implementing the first control switch ($SW_1$), said series and shunt switching arrangement comprising, in addition to the serially connected main transistor ($M_7$) implementing the first control switch ($SW_1$), another serially connected transistor ($M_6$) which is controlled by the same first clock signal ($\Phi_1$) as said main transistor ($M_7$) implementing the first control switch ($SW_1$), and a parallel connected transistor ($M_8$) controlled by the second clock signal ($\Phi_2$).

7. The voltage polarity detection circuit of any one of claims 1 to 6, wherein the two complementary first and second clock signals ($\Phi_1,\Phi_2$) are non-overlapping.

8. The voltage polarity detection circuit of any one of claims 1 to 7, further comprising a reference ground switching arrangement (65), so arranged that the first power supply is the power ground of the power stage of the DC/DC converter during the first phase of operation ($\Phi_1$) and is distinct from said power ground during the second phase of operation ($\Phi_2$).

9. The circuit of any one of claims 1 to 6, wherein the circuit is powered during the first phase of operation ($\Phi_1$), only until the voltage ($V_H z$) at the first input of the comparator crosses the voltage ($V_{c2}$) at the second input of said comparator, and is then be turned off until the beginning of the next conduction cycle of the power switch.

10. A DC/DC converter comprising:

    a. a power stage (10) having at least one power switch FET ($M_2$); and,
    b. at least one voltage polarity detection circuit (30) according to any one of claims 1 to 9.

11. The DC/DC converter of claim 11, wherein the power switch FET ($SW_1$) comprises a power Metal Oxyde Semiconductor, MOS, transistor ($M_1$) and wherein the input voltage of the voltage polarity detection circuit (30) is the drain-source voltage ($V_D S(M_1)$) of said power MOS transistor.

12. A mobile device comprising a DC/DC converter according to claim 10 or 11.

**Patentansprüche**

1. Spannungspolaritäts-Erfassungsschaltung (30), umfassend:

    einen Eingang (31), der konfiguriert ist, um eine Eingangsspannung (VLx) zu empfangen, die für die Leitungsspannung eines Leistungsschalters-FET repräsentativ ist;
    einen Ausgang (32), der konfiguriert ist, um ein Spannungspolaritätserfassungssignal auszugeben;
    eine Stromquelle (61), die angepasst ist, um einen Konstantstrom (I0) auszugeben;
    einen MOS-Transistor (M1) aufweisend:

    - einen Drain, der mit der Stromquelle verbunden ist, um den Konstantstrom zu empfangen,
    - ein Gate, das über einen ersten Kondensator (C1) und einen ersten Steuerschalter (SW1) mit dem Eingang, über einen dritten Steuerschalter (SW3) mit seinem Drain und über den ersten Kondensator (C1) und einen zweiten Steuerschalter (SW2) mit einer ersten Stromversorgung (GND) verbunden ist; und
    - eine Quelle, die mit der ersten Stromversorgung (GND) verbunden ist;

**dadurch gekennzeichnet, dass** die Spannungspolaritäts-Erfassungsschaltung (30) weiter umfasst:
einen Vergleicher, umfassend einen Operationsverstärker (OA), aufweisend:

- einen nichtinvertierenden Eingang, der mit dem Drain des MOS-Transistors verbunden ist,
- einen invertierenden Eingang, der über einen zweiten Kondensator (C2) mit der ersten Stromversorgung (GND) verbunden ist, und
- einen Ausgang, der mit dem nicht-invertierenden Eingang über einen vierten Steuerschalter (SW4) und mit dem Ausgang (32) verbunden ist; wobei die Spannungspolaritäts-Erfassungsschaltung (30) so konfiguriert ist, dass:

während einer ersten Betriebsphase ($\varphi$1), die einem Leitungszyklus des Leistungsschalters-FET entspricht, der erste, zweite und vierte Steuerschalter geschlossen sind und der dritte Steuerschalter geöffnet ist, sodass eine Ausgangsspannung ($V_Hz$) des MOS-Transistors (M1) in den zweiten Kondensator ($C_2$) geladen wird; und

während einer zweiten Betriebsphase ($\phi_2$), die einem Nichtleitungszyklus des Leistungsschalters-FET entspricht; der erste, zweite und vierte Steuerschalter geöffnet sind und der dritte Steuerschalter geschlossen ist, und die Polarität der Eingangsspannung (VLx) am Ende der ersten Betriebsphase durch Vergleichen der im zweiten Kondensator gespeicherten Spannung mit der Ausgangsspannung (VHz) des MOS-Transistors erfasst wird; und wobei

der erste, zweite und vierte Steuerschalter durch ein erstes Taktsignal und der dritte Steuerschalter durch ein zweites Taktsignal gesteuert werden, das zu dem ersten Taktsignal komplementär ist.

2. Spannungspolaritäts-Erfassungsschaltung nach Anspruch 1, weiter umfassend eine Kaskodenstufe mit einem ersten zusätzlichen MOS-Transistor ($M_3$), dessen Quelle mit der Quelle des MOS-Haupttransistors ($M_1$) verbunden ist, dessen Drain mit einer zusätzlichen Stromquelle (62) verbunden ist, die angepasst ist, einen zusätzlichen Konstantstrom ($I_{aux}$) ausgeben kann, und dessen Steuer-Gate mit dem Drain des Haupttransistors ($M_1$) verbunden ist, sowie einen zweiten zusätzlichen MOS-Transistor ($M_4$), dessen Quelle mit dem Drain des Haupttransistors ($M_1$) verbunden ist, dessen Drain mit der Hauptstromquelle (61) zum Empfangen des Hauptkonstantstroms ($I_0$) und dessen Steuer-Gate mit dem Drain des ersten zusätzlichen Transistors ($M_3$) verbunden ist.

3. Spannungspolaritäts-Erfassungsschaltung nach Anspruch 1 oder 2, wobei der dritte Steuerschalter ($SW_3$) durch einen Haupttransistor ($M_5$) implementiert ist, wobei die Spannungspolaritäts-Erfassungsschaltung weiter einen ersten und/oder einen zweiten Blindtransistor umfasst, der in dem Strompfad des Haupttransistors bereitgestellt ist, der den dritten Steuerschalter implementiert, jeweils auf jeder Seite des Haupttransistors, der den dritten Steuerschalter implementiert, nämlich jeweils auf der Drain-Seite und auf der Quellenseite des Haupttransistors, wobei die ersten und/oder zweiten Blindtransistoren jeweils durch das erste Taktsignal gesteuert werden.

4. Spannungspolaritäts-Erfassungsschaltung nach Anspruch 3, wobei die ersten und/oder zweiten Blindtransistoren eine Größe von 0,5xW und 1xL, jeweils verglichen mit der Größe W und L des Haupttransistors, aufweisen.

5. Spannungspolaritäts-Erfassungsschaltung nach einem der Ansprüche 1 bis 4, wobei der vierte Steuerschalter ($SW_4$) durch einen Haupttransistor ($M_{12}$) implementiert ist, wobei die Spannungspolaritäts-Erfassungsschaltung weiter einen Blindtransistor umfasst, der im Strompfad des Haupttransistors, der den vierten Steuerschalter implementiert, auf der Seite des zweiten Kondensators ($C_2$) bereitgestellt ist, wobei der Blindtransistor durch das zweite Taktsignal gesteuert wird.

6. Spannungspolaritäts-Erfassungsschaltung nach einem der Ansprüche 1 bis 5, wobei der erste Steuerschalter ($SW_1$) durch einen Haupttransistor ($M_7$) implementiert ist, wobei die Spannungspolaritäts-Erfassungsschaltung weiter eine Reihen- und Nebenschluss-Schaltanordnung (64) umfasst, die dem Haupttransistor zugeordnet ist, der den ersten Steuerschalter ($SW_1$) implementiert, wobei die Reihen- und Nebenschluss-Schaltanordnung zusätzlich zu dem seriell verbundenen Haupttransistor ($M_7$), der den ersten Steuerschalter ($SW_1$) implementiert, einen weiteren seriell verbundenen Transistor ($M_8$), der durch das gleiche erste Taktsignal ($\phi_1$) gesteuert wird wie der Haupttransistor ($M_7$), der den ersten Steuerschalter ($SW_1$) implementiert, und einen parallel verbundenen Transistor ($M_8$), der durch das zweite Taktsignal ($\phi_2$) gesteuert wird, umfasst.

7. Spannungspolaritäts-Erfassungsschaltung nach einem der Ansprüche 1 bis 6, wobei die beiden komplementären ersten und zweiten Taktsignale ($\phi_1, \phi_2$) nicht überlappend sind.

**8.** Spannungspolaritäts-Erfassungsschaltung nach einem der Ansprüche 1 bis 7, weiter umfassend eine Bezugsmasse-Schaltungsanordnung (65), so angeordnet, dass die erste Stromversorgung die Leistungsmasse der Leistungsstufe des DC/DC-Wandlers während der ersten Betriebsphase ($\phi_1$) ist und sich von der Leistungsmasse während der zweiten Betriebsphase ($\phi_2$) unterscheidet.

**9.** Schaltung nach einem der Ansprüche 1 bis 6, wobei die Schaltung während der ersten Betriebsphase ($\phi_1$) nur so lange mit Leistung versorgt wird, bis die Spannung ($V_H$z) am ersten Eingang des Vergleichers die Spannung ($V_{c2}$) am zweiten Eingang des Vergleichers erreicht und dann bis zum Beginn des nächsten Leitungszyklus des Leistungsschalters ausgeschaltet wird.

**10.** Ein DC/DC-Wandler, umfassend:

a. eine Leistungsstufe (10) aufweisend mindestens einen Leistungsschalter-FET ($M_2$); und
b. mindestens eine Spannungspolaritäts-Erfassungsschaltung (30) nach einem der Ansprüche 1 bis 9.

**11.** DC/DC-Wandler nach Anspruch 11, wobei der Leistungsschalter-FET ($SW_1$) einen Leistungs-Metall-Oxid-Halbleiter-, MOS-, Transistor ($M_1$) umfasst und wobei die Eingangsspannung der Spannungspolaritäts-Erfassungsschaltung (30) die Drain-Quelle-Spannung ($V_D$s($M_1$)) des Leistungs-MOS-Transistors ist.

**12.** Mobilgerät, umfassend einen DC/DC-Wandler nach Anspruch 10 oder 11.


**Revendications**

**1.** Circuit de détection de polarité de tension (30) comprenant :

une entrée (31) configurée pour recevoir une tension d'entrée (VLx) représentative de la tension de conduction d'un commutateur de puissance FET ;
une sortie (32) configurée pour produire un signal de détection de polarité de tension ;
une source de courant (61) adaptée pour produire un courant constant (I0) ;
un transistor MOS (M1) ayant :

- un drain raccordé à la source de courant pour recevoir ledit courant constant,
- une grille raccordée à l'entrée à travers un premier condensateur (C1) et un premier commutateur de commande (SW1) à son drain à travers un troisième commutateur de commande (SW3) et à une première alimentation électrique (GND) à travers le premier condensateur (C1) et un deuxième commutateur de commande (SW2) ; et
- une source raccordée à la première alimentation électrique (GND) ;

**caractérisé en ce que** le circuit de détection de polarité de tension (30) comprend en outre :
un comparateur comprenant un Amplificateur Opérationnel (OA) ayant :

- une entrée non inverseuse raccordée au drain du transistor MOS,
- une entrée inverseuse raccordée à la première alimentation électrique (GND) à travers un second condensateur (C2), et
- une sortie raccordée à l'entrée non inverseuse à travers un quatrième commutateur de commande (SW4) et à la sortie (32) ; dans lequel le circuit de détection de polarité de tension (30) est configuré de sorte que :

durant une première phase de fonctionnement ($\varphi 1$) correspondant à un cycle de conduction du commutateur de puissance FET, les premier, deuxième et quatrième commutateurs de commande soient fermés et le troisième commutateur de commande soit ouvert, de sorte qu'une tension de sortie ($V_HZ$) du transistor MOS (M1) soit chargée dans le second condensateur ($C_2$) ; et
durant une seconde phase de fonctionnement ($\phi 2$) correspondant à un cycle de non-conduction du commutateur de puissance FET, les premier, deuxième et quatrième commutateurs de commande soient ouverts et le troisième commutateur de commande soit fermé, et la polarité de la tension d'entrée (VLx) à la fin de la première phase de fonctionnement soit détectée en comparant la tension stockée dans le second condensateur avec la tension de sortie (VHz) du transistor MOS ; et dans lequel les premier, deuxième et quatrième commutateurs de commande sont entraînés par un premier signal d'horloge et le troisième commutateur de commande est entraîné par un second signal d'horloge complémentaire au premier signal d'horloge.

**2.** Circuit de détection de polarité de tension selon la revendication 1, comprenant en outre un étage cascode ayant un premier transistor MOS supplémentaire ($M_3$) dont la source est raccordée à la source du transistor MOS principal ($M_1$), dont le drain est raccordé à une source de courant supplémentaire (62) adaptée pour produire un courant constant supplémentaire ($I_{aux}$), et dont la grille de commande est raccordée au drain dudit transistor principal ($M_1$), ainsi qu'un second transistor MOS supplémentaire ($M_4$) dont la source est raccordée au drain du transistor principal ($M_1$), dont le drain est raccordé à la source de courant principale (61) pour recevoir le courant constant principal ($I_0$), et dont la grille de commande est raccordée au drain du premier transistor supplémentaire ($M_3$).

**3.** Circuit de détection de polarité de tension selon la revendication 1 ou 2, dans lequel le troisième commutateur de commande ($SW_3$) est mis en œuvre par un transistor principal ($M_5$), le circuit de détection de polarité de tension comprenant en outre un premier et/ou un second transistor fictif fourni dans le trajet de courant dudit transistor principal mettant en œuvre le troisième commutateur de commande, sur l'un ou l'autre côté dudit transistor principal mettant en œuvre le troisième commutateur de commande, respectivement, à savoir sur le côté du drain et sur le côté de la source dudit transistor principal, respectivement, lesdits premier et/ou second transistors fictifs étant chacun commandés par le premier signal d'horloge.

**4.** Circuit de détection de polarité de tension selon la revendication 3, dans lequel les premier et/ou second transistors fictifs ont une taille de 0,5 x W et de 1 x L, comparée à la taille W et L dudit transistor principal, respectivement.

**5.** Circuit de détection de polarité de tension selon l'une quelconque des revendications 1 à 4, dans lequel le quatrième commutateur de commande ($SW_4$) est mis en œuvre par un transistor principal ($M_{12}$), le circuit de détection de polarité de tension comprenant en outre un transistor fictif fourni dans le trajet de courant dudit transistor principal mettant en œuvre le quatrième commutateur de commande, sur le côté du second condensateur ($C_2$), ledit transistor fictif étant commandé par le second signal d'horloge.

**6.** Circuit de détection de polarité de tension selon l'une quelconque des revendications 1 à 5, dans lequel le premier commutateur de commande ($SW_1$) est mis en œuvre par un transistor principal ($M_7$), le circuit de détection de polarité de tension comprenant en outre un agencement de commutation en série et shunt (64) associé audit transistor principal mettant en œuvre le premier commutateur de commande ($SW_1$), ledit agencement de commutation en série et shunt comprenant, en plus du transistor principal raccordé en série ($M_7$) mettant en œuvre le premier commutateur de commande ($SW_1$), un autre transistor raccordé en série ($M_6$) qui est commandé par le même premier signal d'horloge ($\phi 1$) que ledit transistor principal ($M_7$) mettant en œuvre le premier commutateur de commande ($SW_1$), et un transistor raccordé en parallèle ($M_8$) commandé par le second signal d'horloge ($\phi 2$).

**7.** Circuit de détection de polarité de tension selon l'une quelconque des revendications 1 à 6, dans lequel les deux premier et second signaux d'horloge complémentaires ($\phi_1$, $\phi 2$) sont non chevauchants.

**8.** Circuit de détection de polarité de tension selon l'une quelconque des revendications 1 à 7, comprenant en outre un agencement de commutation de terre de référence (65), agencé de sorte que la première alimentation électrique soit la terre électrique de l'étage électrique du convertisseur CC/CC durant la première phase de fonctionnement ($\phi_1$) et soit distinct de ladite terre électrique durant la seconde phase de fonctionnement ($\phi_2$).

**9.** Circuit de détection de polarité de tension selon l'une quelconque des revendications 1 à 6, dans lequel le circuit est alimenté durant la première phase de fonctionnement ($\phi_1$), uniquement jusqu'à ce que la tension ($V_H z$) au niveau de la première entrée du comparateur croise la tension ($V_{c2}$) au niveau de la seconde entrée dudit comparateur, et est alors éteint jusqu'au début du cycle de conduction suivant du commutateur de puissance.

**10.** Convertisseur CC/CC comprenant :

a. un étage électrique (10) ayant au moins un commutateur de puissance FET ($M_2$) ; et,
b. au moins un circuit de détection de polarité de tension (30) selon l'une quelconque des revendications 1 à 9.

**11.** Convertisseur CC/CC selon la revendication 11, dans lequel le commutateur de puissance FET ($SW_1$) comprend un transistor métal-oxyde-semiconducteur, MOS, de puissance ($M_1$) et dans lequel la tension d'entrée du circuit de détection de polarité de tension (30) est la tension drain-source ($V_D S(M_1)$) dudit transistor MOS de puissance.

**12.** Dispositif mobile comprenant un convertisseur CC/CC selon la revendication 10 ou 11.

FIG. 1A

FIG. 1B

FIG. 1C

FIG. 2

FIG. 3

FIG. 4

FIG. 5

FIG. 7

**FIG. 6**

EP 2 736 156 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011291632 A

- EP 0049024 A2

**Non-patent literature cited in the description**

- Analogue IC Design: The Current-Mode Approach. **CHRIS TOUMAZOU ; F. J. LIDGEY ; DAVID HAIGH.** Principle of dynamic current mirrors. 1993, 302-303